Europäisches Patentamt

European Patent Office

Office européen des brevets

(19)

(11) Veröffentlichungsnummer: **0 171 683**
**B1**

(12) EUROPÄISCHE PATENTSCHRIFT

(45) Veröffentlichungstag der Patentschrift:
**26.10.88**

(51) Int. Cl.⁴: **G 01 N 24/04, G 01 N 24/08**

(21) Anmeldenummer: **85109388.0**

(22) Anmeldetag: **26.07.85**

(54) **Kernspintomographiegerät.**

(30) Priorität: **09.08.84 DE 3429386**

(43) Veröffentlichungstag der Anmeldung:
**19.02.86 Patentblatt 86/8**

(45) Bekanntmachung des Hinweises auf die Patenterteilung:
**26.10.88 Patentblatt 88/43**

(84) Benannte Vertragsstaaten:
**DE FR GB NL**

(56) Entgegenhaltungen:
**EP - A - 0 074 022**
**WO - A - 84/00214**
**GB - A - 2 056 081**
**US - A - 4 240 439**

(73) Patentinhaber: **Siemens Aktiengesellschaft Berlin und München, Wittelsbacherplatz 2, D-8000 München 2 (DE)**

(72) Erfinder: **Fritschy, Peter, Dr., Inselspital, CH-3010 Bern (CH)**
Erfinder: **Weber, Horst, Dr., Am Fürstenberg 7, D-8555 Adelsdorf (DE)**
Erfinder: **Lorenz, Walter J., Prof. Dr., Kastellweg 26, D-6900 Heidelberg (DE)**
Erfinder: **Pastyr, Otto, Mannheimerweg 6, D-6906 Leimen (DE)**
Erfinder: **Sturm, Volker, Prof. Dr., Höhenweg 5, D-6908 Wiesloch 5 (DE)**
Erfinder: **Zabel, Hans-Joachim, Dr., Freiburgerstrasse 43, D-6900 Heidelberg (DE)**
Erfinder: **Bader, Reiner, Dr., Gerhart-Hauptmann-Strasse 18, D-6900 Heidelberg (DE)**

**Beschreibung**

Die Erfindung betrifft ein Kernspintomographiegerät zur Darstellung von Teilbereichen aus dem Innern eines Untersuchungsobjektes mit Spulen zum Anlegen von magnetischen Grund- und Gradientenfeldern an das Untersuchungsobjekt und mindestens einer Messspule zum Erfassen der Auslenkung der Kernspins des Untersuchungsobjektes aus ihrer Gleichgewichtslage durch hochfrequente, magnetische Anregungsimpulse (90°-Hf-Impuls und 180°-Hf-Impuls).

Ein Gerät dieser Art ist in der deutschen Patentanmeldung 3 135 335 beschrieben. Durch dieses Gerät ist es möglich, insbesondere die Kernspins eines Untersuchungsobjektes aus einer Vorzugsrichtung, die durch ein Magnet-Grundfeld erzeugt wird, durch einen hochfrequenten Anregungsimpuls auszulenken und beim Einpendeln der Kernspins nach dem Ende des Anregungsimpulses, d.h. bei der Präzision der Kernspins, ein Signal zu erzeugen, dessen Frequenz von der Stärke des Magnet-Grundfeldes abhängt. Überlagert man dem homogenen Magnet-Grundfeld einen Feldgradienten, so dass die Magnetfeldverteilung räumlich variiert, so ist eine Ortung über die jeweils gemessene Frequenz möglich. Auf diese Weise und durch Änderung der Richtung des Feldgradienten können auch Schichtbilder des Untersuchungsobjektes erzeugt werden. Die Anregung in einer Schicht des Untersuchungsobjektes erfolgt dabei dadurch, dass das Magnet-Grundfeld durch einen weiteren Feldgradienten so beeinflusst wird, dass nur in dieser Schicht eine Anregung der Kernspins erfolgt. Dies ist möglich, weil die Anregung nur mit einer Frequenz erfolgt, die dem Magnetfeld in der gewünschten Schicht streng zugeordnet ist.

Zur lokalen Behandlung von Tumorzellen im menschlichen Gehirn werden radioaktive Substanzen direkt in die Tumorzelle implantiert. Die Implantation erfolgt durch kleine Kunststoffkanäle, die zuvor durch eine stereotaktische Operation eingebracht wurden. Ferner ist es bekannt, Körperorgane, wie Leber, Niere, mit Hilfe einer hohlen Biopsienadel zu untersuchen.

Der Erfindung liegt die Aufgabe zugrunde, die operativ gelegten Kanäle zu bestimmten Körperorganen, wie dem Gehirn, der Leber und der Niere für die Erzeugung ortsaufgelöster Spektren zu nutzen.

Die Erfindung geht von der Erkenntnis aus, dass durch die genannten Kanäle eine Messspule bei entsprechender Ausbildung in das Körperinnere eingeführt werden kann, die dann am Applikationsort zur Erzeugung spektroskopischer Informationen benutzt werden kann. Die der Erfindung zugrundeliegende Aufgabe ist demgemäss dadurch gelöst, dass als Messspule eine auf einem dünnen Träger von grössenordnungsmässig wenigen Quadratmillimetern Querschnittsfläche aufgebrachte Spule vorgesehen ist. Diese Spule kann vorzugsweise eine Länge von 10 bis 20 mm haben.

Die Erfindung ist nachfolgend anhand der Zeichnung näher erläutert. Es zeigen:

Fig. 1 ein Kernspintomographiegerät zur Erläuterung des Erfindungsgedankens,

Fig. 2 eine erfindungsgemässe Ausbildung einer Messspule für das Kernspintomographiegerät gemäss Figur 1, und

Fig. 3 eine Variante der Messspule gemäss Figur 2.

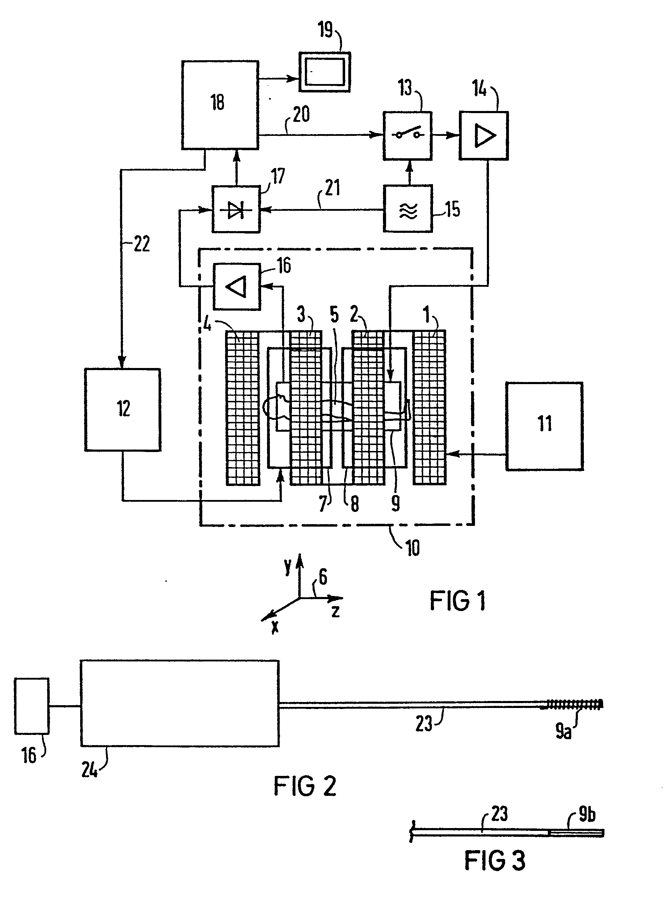

In der Figur 1 sind mit 1 und 2 sowie 3 und 4 Spulen gekennzeichnet, mit welchen ein magnetisches Gleichfeld $B_0$ erzeugt wird, in welchem sich bei Anwendung zur medizinischen Diagnostik der zu untersuchende Körper 5 eines Patienten befindet. Diesem sind ausserdem Gradientenspulen zugeordnet, die zur Erzeugung unabhängiger, zueinander senkrechter Magnetfeldgradienten der Richtungen x, y und z gemäss der Andeutung in 6 vorgesehen sind. In der Figur 1 sind der Übersichtlichkeit halber nur Gradientenspulen 7 und 8 gezeichnet, die zusammen mit einem Paar gegenüberliegender, gleichartiger Gradientenspulen zur Erzeugung des x-Gradienten dienen. Die gleichartigen, nicht gezeichneten y-Gradientenspulen liegen parallel zum Körper 5 und oberhalb sowie unterhalb von ihm und die für das z-Gradientenfeld quer zu seiner Längsachse am Kopf- und am Fussende. Die Anordnung enthält ausserdem noch eine zur Anregung der Kernresonanz und Aufnahme der Kernresonanzsignale dienende Hochfrequenzspule 9.

Die von einer strichpunktierten Linie 10 umgrenzten Spulen 1 bis 9 stellen das eigentliche Untersuchungsinstrument dar. Es wird von einer elektrischen Anordnung aus betrieben, die ein Netzgerät 11 zum Betrieb der Spulen 1 bis 4 sowie eine Gradientenstromversorgung 12, an welcher die Gradientenspulen 7 und 8 sowie die weiteren Gradientenspulen liegen, umfasst. Die sowohl zur Anregung als auch zur Aufnahme des Signales dienende Messspule 9 liegt einerseits über einen Modulator 13 und einen Sendeverstärker 14 an einem Hochfrequenzoszillator 15 und andererseits über einen Signalverstärker 16 und einen phasenempfindlichen Gleichrichter 17 an einem Prozessrechner 18, von dem aus zur Ausgabe der Abbildung ein Bildschirmgerät 19 versorgt wird. Zur Steuerung der Anordnung sind ausserdem noch Verbindungen 20, 21 und 22 zwischen dem Rechner 18 und dem Modulator 13 sowie dem Oszillator 15 und dem Gleichrichter 17 sowie dem Rechner 18 und der Gradientenstromversorgung 12 vorgesehen. Die prinzipielle Wirkungsweise eines Gerätes der Figur 1 ist in der deutschen Offenlegungsschrift P 3 135 335.5 beschrieben.

Bei dem Gerät gemäss Figur 1 ist die Messspule 9 so ausgebildet, dass Schnittbilder des Körpers 5 dargestellt werden können.

Die Figur 2 zeigt, dass eine weitere Messspule 9a vorgesehen ist, die auf einem Kunststoffträger 23 von grössenordnungsmässig 2 mm Durchmesser aufgewickelt und elektrisch an einer Abstimmeinheit 24 angeschlossen ist, welche ihrerseits mit dem Signalverstärker 16 und dem Sendeverstärker 14 verbindbar ist. Die Messspule 9a hat eine Länge von 18 mm, während der Kunststoffträger insgesamt eine Länge von etwa 100 mm hat. Die Ausbildung der Messspule 9a erlaubt es, diese mit Hilfe des Kunststoffträgers 23 in einen Kanal des menschlichen Körpers, z.B. direkt an einen Tumor, zu führen, um spektroskopische Informationen zu erhalten. Das empfindliche Volumen liegt aufgrund der gewählten Geometrie ausserhalb der Messspule 9a. Man erhält kugelförmige Messvolumina von ca. 7 mm Durchmesser, die jeweils die Enden der Spule umgeben. Die Messspule 9a gemäss Figur 2 eignet sich zur Untersuchung im Bereich des menschlichen Gehirns, aber auch im Bereich anderer Organe, die durch Hohlnadeln zugänglich sind, wie der Leber und der Niere.

Der Querschnitt der Messspule 9a kann kreisförmig, aber auch quadratisch oder rechteckig sein. Die Achse der Messspule 9a fällt mit der Achse des Kunststoffträgers 23 zusammen (Fig. 2). Sie kann aber auch senkrecht dazu stehen. Im letzteren Falle ist es leichter möglich, die Messspule 9b (Fig. 3) in bezug auf das statische Magnetfeld und auf die Hochfrequenzspule 9 durch Drehung des Kunststoffträgers 23 optimal auszurichten. Die Achse der Messspule sollte nämlich senkrecht zum statischen Magnetfeld und zur Achse der Hochfrequenzspule 9 liegen. Die Messspule 9b ist dabei als Rahmenspule mit rechteckigem Querschnitt ausgebildet und am Ende des Trägers 23 befestigt, z.B. angeklebt.

## Patentansprüche

1. Kernspintomographiegerät zur Darstellung von Teilbereichen aus dem Innern eines Untersuchungsobjektes (5) mit Spulen (1 bis 8) zum Anlegen von magnetischen Grund- und Gradientenfeldern an das Untersuchungsobjekt (5) und mindestens einer Messspule (9, 9a) zum Erfassen der Auslenkung der Kernspins des Untersuchungsobjektes aus ihrer Gleichgewichtslage durch hochfrequente magnetische Anregungsimpulse, z.B. 90°-Hf-Impulse und 180°-Hf-Impulse, dadurch gekennzeichnet, dass als Messspule (9a) eine auf einem dünnen Träger (23) von grössenordnungsmässig wenigen Quadratmillimetern Querschnittsfläche aufgebrachte Spule vorgesehen ist.

2. Gerät nach Anspruch 1, dadurch gekennzeichnet, dass die Messspule (9a) eine Länge von 10 bis 20 mm hat.

3. Gerät nach Anspruch 1 oder 2, dadurch gekennzeichnet, dass die Messspule (9b) als Rahmenspule mit rechteckigem Querschnitt ausgebildet und am Ende des Trägers (23) befestigt ist.

## Claims

1. Nuclear spin tomography apparatus, for depicting parts of areas of the inside of a subject being examined (5), having coils (1 to 8) for setting up a fundamental magnetic field and a field gradient on the subject being examined (5) and with at least one measuring coil (9, 9a) for detecting the deflection from the position of equilibrium of the nuclear spins of the subject being examined by means of high frequency magnetic excitation impulses e.g. 90°-Hf-impulses and 180°-Hf-impulses, characterised in that there is provided as a measuring coil (9a) a coil mounted on a thin carrier (23) having a cross-sectional area of the order of a few square millimetres.

2. Apparatus according to claim 1, characterised in that the measuring coil (9a) has a length of 10 to 20 mm.

3. Apparatus according to claim 1 or 2, characterised in that the measuring coil (9b) is constructed as a frame coil with a right-angled cross-section and is fixed to the end of the carrier (23).

## Revendications

1. Appareil de tomographie à spin nucléaire pour la représentation de zones partielles de l'intérieur d'un sujet (5) à examiner, comportant des bobines (1 à 8) servant à appliquer des champs de base et des champs irrotationnels magnétiques au sujet (5) à examiner, et au moins une bobine de mesure (9, 9a) servant à détecter la déviation du spin nucléaire du sujet à examiner à partir de sa position d'équilibre, au moyen d'impulsions d'excitation magnétiques à haute fréquence, par exemple des impulsions HF à 90° et des impulsions HF à 180°, caractérisé par le fait qu'on utilise, comme bobine de mesure (9a), une bobine placée sur un support mince (23) possédant une surface en coupe transversale de l'ordre de quelques millimètres carrés.

2. Appareil suivant la revendication 1, caractérisé par le fait que la bobine de mesure (9a) possède une longueur comprise entre 10 et 20 mm.

3. Appareil suivant la revendication 1 ou 2, caractérisé par le fait que la bobine de mesure (9b) est réalisée sous la forme d'une bobine en forme de cadre possédant une section transversale rectangulaire et est fixée à l'extrémité du support (23).

FIG 1

FIG 2

FIG 3